# FASCICULE DE BREVET EUROPEEN

(11) **EP 2 823 273 B1**
(45) Date de publication et mention de la délivrance du brevet: **29.05.2019**
(21) Numéro de dépôt: 13707416.7
(22) Date de dépôt: 06.03.2013
(51) Int. Cl.: G01L 9/00, G01L 9/04, G01L 9/06, G01L 19/00, G01L 19/14, B81C 1/00, B81B 7/02, B81B 7/00, B32B 38/08, B81B 3/00

(54) **PROCEDE DE FABRICATION D'UN CAPTEUR DE PRESSION**
VERFAHREN ZUR HERSTELLUNG EINES DRUCKSENSORS
METHOD FOR PRODUCING A PRESSURE SENSOR

(30) Priorité: 06.03.2012 FR 1252042
(43) Date de publication de la demande: 14.01.2015
(73) Titulaire: Auxitrol SA, 18000 Bourges (FR); CENTRE NATIONAL DE LA RECHERCHE SCIENTIFIQUE (CNRS), 75016 Paris (FR)
(72) Inventeur: BRIDA, Sébastiano, F-11410 Salles sur L'Hers (FR); LE NEAL, Jean-François, CH-2000 Neuchatel (CH)
(74) Mandataire: Regimbeau
(86) Numéro de dépôt international: PCT/EP2013/054531
(87) Numéro de publication internationale: WO 2013/131973

(56) Documents cités:
- WO-A1-02/08713
- JP-A- 2008 002 994
- US-A1- 2004 103 724
- US-A1- 2011 073 969

## Description

### DOMAINE TECHNIQUE GENERAL

L'invention concerne la fabrication d'une structure micromécanique pour mesurer ou détecter une grandeur mécanique ou une grandeur physique et en particulier un capteur de pression comprenant une telle microstructure.

### ETAT DE LA TECHNIQUE

De manière connue, un capteur de pression comprend une structure micromécanique (en anglais, « *Micro Electro Mechanical Systems* », (MEMS)) comprenant une membrane déformable assemblée à un support partiellement séparés par une cavité dans laquelle règne une pression de référence, par exemple le vide.

Des jauges de contrainte supportées par la membrane peuvent alors mesurer des contraintes provoquées par des déformations que subit la membrane soumise à un apport d'énergie externe (telle que par exemple une pression P appliquée sur la membrane), en observant les modifications de propriétés physiques et/ou électriques de la structure associées aux déformations (telles que par exemple un changement de résistance électrique ou de contraintes internes).

Des capteurs de pression de ce type sont destinés à être utilisé dans des environnements hostiles et doivent être protégés du milieu extérieur.

Pour ce faire, la structure micromécanique est placée dans un boitier de protection : encapsulation de la structure micromécanique (plus généralement on parle d'encapsulation de la structure micromécanique quand il s'agit de protéger la structure micromécanique). Une fois dans le boitier, la pression à mesurer est transmise du boitier aux jauges de contrainte par l'intermédiaire d'une interface de transmission généralement constituée d'huile. Une telle mise en boitier est connue sous son nom anglais de « *packaging* ».

Un tel *packaging* présente toutefois des inconvénients.

La présence d'huile limite l'utilisation du capteur ainsi obtenu à une température de l'ordre de 200°C.

En outre, le capteur présente une précision limitée par la présence d'éléments intermédiaires ayant des interactions avec la structure micromécanique (telles que l'huile et la colle), affectant en particulier la précision et la stabilité à long terme.

Depuis quelques années, pour pallier ces inconvénients, l'encapsulation de la structure micromécanique peut être mise en oeuvre au moment de la fabrication de la structure micromécanique (en anglais, « *Wafer Level Packaging* »).

Les procédés connus présentent toutefois les inconvénients suivants.

Le choix des matériaux utilisés pour définir les contacts électriques sont limités ce qui entraine des contraintes au cours de l'assemblage de la structure.

Une pâte de verre est souvent utilisée pour les connexions ce qui créé des résistances de contact non négligeables, qui peuvent évoluer au cours du temps sous l'effet de la température.

Des fils électriques sont utilisés ce qui peut fragiliser la structure.

Les documents US 2004103724, US 2011073969, JP 2008 002994 et WO 02/08713 divulguent des capteurs de pression connus.

L'invention s'inscrit dans ce contexte pour proposer un procédé de fabrication d'un capteur de pression.

### PRESENTATION DE L'INVENTION

L'invention propose, selon un premier aspect, un procédé de fabrication d'un capteur qui de part sa conception même, permet de regrouper en une seule phase la fabrication et la protection d'un élément sensible de structure micromécanique.

A cet effet, l'invention propose un procédé de fabrication d'un capteur de pression comprenant les étapes suivantes :
assemblage d'un substrat support avec une membrane déformable sur laquelle des jauges de contraintes ont été déposées, la membrane déformable comprenant une zone amincie en son centre, le substrat support étant disposé au-dessus de la membrane déformable, le substrat support comprenant une surface supérieure, une surface inférieure en contact avec la membrane déformable, le substrat support comprenant en outre des évidements latéraux disposés au-dessus et en face des jauges de contraintes et un évidement central disposé au-dessus la zone amincie de la membrane, ceci pour obtenir une structure micromécanique ; et une fois l'assemblage effectué, le procédé comprenant l'étape suivante :
dépôt en une unique étape d'au moins un matériau conducteur sur la surface supérieure du support et dans les évidements latéraux du support, le matériau conducteur s'étendant dans les évidements pour être en contact direct avec les jauges de contraintes afin de former des contacts électriques en liaison avec les jauges de contraintes.

L'invention est avantageusement complétée par les caractéristiques suivantes, prises seules ou en une quelconque de leur combinaison techniquement possible :
- il comprend une étape de formation de plusieurs contacts électriques mise en oeuvre par photolithographie associé à une technique de laminage 3D à chaud ou de revêtement par pulvérisation de surfaces de forte topologie ;
- le ou les matériau(x) conducteur(s) sont choisis parmi le groupe suivant : polysilicium ultra dopé, Au, Ag, Ni, Pt, TiW, Cu, Pd, Al, Ti, TiN ;
- la membrane est en silicium et : le support est en verre, l'assemblage consistant en un scellement anodique ; ou le support est en silicium, l'assemblage consistant en un scellement au moyen d'une liaison moléculaire ou atomique avec ou sans couche intermédiaire, ou par brasage ;

- il comprend une étape consistant à : intégrer le support à un boitier comprenant des contacts électriques en matériau conducteur ; le support étant intégré au boitier par l'intermédiaire des connecteurs formés sur le support ;
- l'intégration du support au boitier est effectuée par un procédé de thermocompression ;
- le procédé de thermo compression est mis en oeuvre avec une température comprise entre 250°C et 500°C, typiquement 320°C avec une pression comprise entre 10 MPa et 200 MPa, typiquement 50 MPa ;
- les contacts électriques du boitier sont en matériau choisi parmi le groupe suivant : polysilicium ultra dopé, Au, Ag, Ni, Pt, TiW, Cu, Pd, Al, Ti, TiN ;
- l'intégration du substrat support au boitier est mise en oeuvre au moyen de la technique de la puce retournée ;
- la membrane est formée à partir d'un substrat, par exemple constitué de silicium monocristallin comme le SOI ou le PSOI, de saphir comme le SOS ou bien d'autres matériaux comme le SiCOI ou le SiC.

L'invention présente de nombreux avantages.

L'assemblage du support avec la membrane déformable étant effectué avant le dépôt d'au moins un matériau conducteur pour obtenir ensuite les contacts électriques, le choix des matériaux est supérieur à celui des techniques connues.

L'invention permet d'éviter d'utiliser des éléments supplémentaires pour créer la connectique au niveau des jauges de contraintes : le dépôt du matériau conducteur est effectué en une seule étape et conduit à la formation des contacts électriques.

En outre, le procédé de l'invention permet de déposer plusieurs matériaux conducteurs successifs après l'assemblage pour améliorer les contacts électriques d'une part, et faciliter l'intégration du support à un boîtier de connexion d'autre part.

En outre, avec le procédé de l'invention la qualité d'assemblage du support avec la membrane déformable est accrue car la qualité de surface des deux composants est non altérée par les étapes de gravure qui sont réalisées dans ce cas en aval de l'assemblage.

Par ailleurs, la température de scellement n'est pas limitée par le choix des matériaux conducteurs.

Un autre intérêt est que la connexion électrique par contact métallique direct, présente une résistance de contact négligeable par rapport à la mesure en elle-même, et elle est non sujette aux variations de températures.

Par ailleurs, l'intégration par la technique dite de la puce retournée (en anglais, « *flip chip* ») en une seule étape, ne nécessite pas un apport d'autres matériaux qui pourraient créer des limitations lors du procédé de fabrication et/ou des contraintes mécaniques entre matériaux dues à l'intégration par thermocompression.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- les figures 1a, 1b et 1c illustrent l'assemblage d'une membrane déformable et d'un support selon un procédé conforme à un mode de réalisation de l'invention ;
- la figure 1d illustre un dépôt d'une barrière de diffusion selon un exemple ne faisant pas partie de l'invention;
- les figures 2a et 2b illustrent le dépôt d'un ou plusieurs matériaux conducteurs selon un procédé conforme à un premier mode de réalisation de l'invention ;
- les figures 2c et 2d illustrent le dépôt d'un ou plusieurs matériaux conducteurs selon un exemple ne faisant pas partie de l'invention;

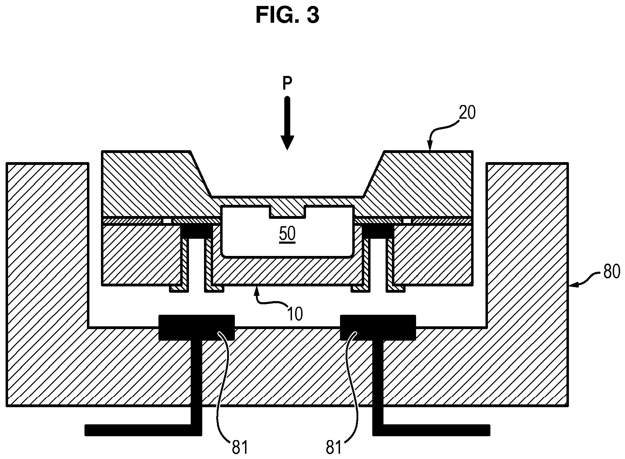

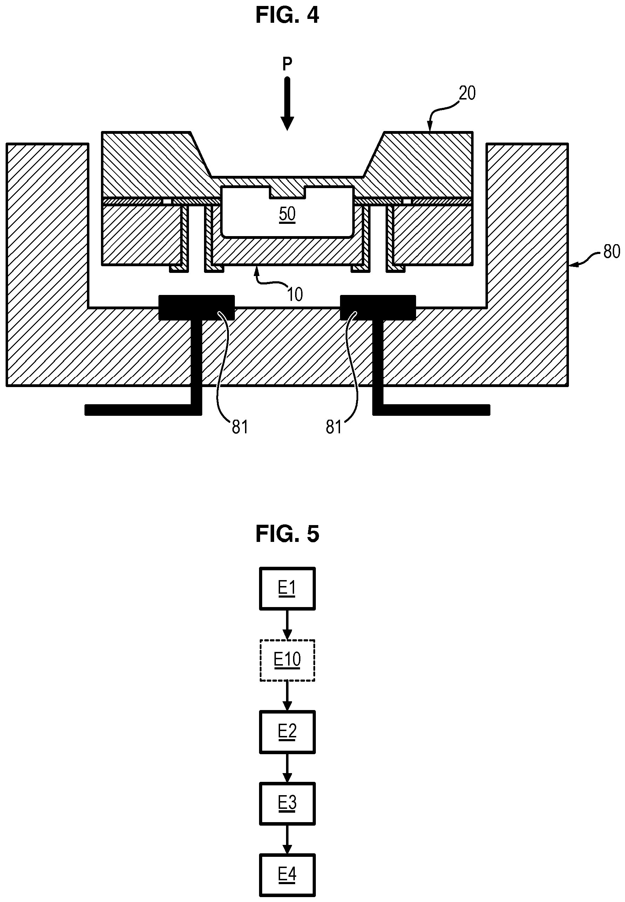

- la figure 3 illustre la mise en boîtier selon un exemple ne faisant pas partie de l'invention et la figure 4 illustre la mise en boitier selon un procédé conforme à un premier mode de réalisation de l'invention ;
- la figure 5 illustre des étapes d'un procédé conforme à un mode de réalisation de l'invention.

Sur l'ensemble des figures, les éléments similaires portent des références identiques.

### DESCRIPTION DETAILLEE DE L'INVENTION

Un capteur de pression comprend notamment un support 10 et une membrane déformable 20, des jauges de contrainte 30 et des supports 40 d'assemblage disposées entre le support 10 et la membrane 20.

La mesure de la pression peut être absolue ou bien différentielle.

La structure micromécanique formée par la membrane déformable et les jauges de contraintes sont donc protégées par le support 10.

La structure micromécanique est connectée électriquement à un boitier 80 par l'intermédiaire du support 10 qui comprend des contacts électriques 61, le boitier 80 comprenant également des contacts électriques 81 disposés à l'intérieur.

De manière avantageuse, la membrane déformable 20 comprend une surface supérieure 201 et une surface inférieure 202, un diaphragme sensible à la pression / ou partie fine 20b suspendue au-dessus d'un espace libre et une partie épaisse 20a formant support de la partie fine 20b.

Une telle membrane 20 est typiquement formée à partir d'un substrat, par exemple constitué de silicium monocristallin comme le SOI ou le PSOI, de saphir comme le SOS ou bien d'autres matériaux comme le SiCOI ou le SiC.

L'espace libre (au niveau de la partie fine 20b de la membrane) est avantageusement formé par micro-usinage.

Les techniques de micro-usinage employées pour former un tel espace libre peuvent par exemple être de la gravure chimique, telle qu'une gravure KOH à une température déterminée et/ou une gravure profonde par ions réactifs (en anglais, « *Deep Reactive Ion Etch* », (DRIE)) dans un substrat de surface d'origine plane.

Les épaisseurs d'une telle membrane 20 sont de plusieurs dizaines de microns, de 100 µm à 1000µm, typiquement de 500 µm pour la partie épaisse 20a, et de 10 à 200 µm pour la partie fine 20b.

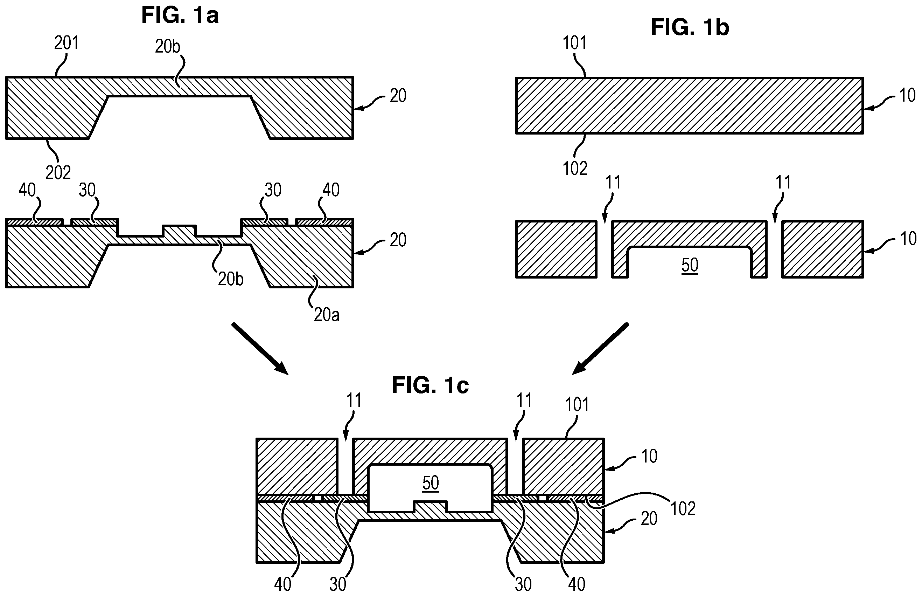

La membrane déformable 20 comprend sur sa partie supérieure des jauges de contrainte 30. Les jauges de contrainte 30 sont constituées par des microstructures en silicium monocristallin situées sur la surface supérieure 201 de la membrane déformable 20 (voir la figure 1a). Typiquement, ces microstructures sont habituellement formées à partir d'une couche de silicium initiale gravée par photolithographie et gravure chimique ou plasma.

Les jauges de contraintes 30 sont de préférence disposées dans la zone de contrainte mécanique maximale de la membrane déformable 20.

La membrane déformable 20 comprend en outre sur sa surface supérieure 201 des supports 40 d'assemblage qui sont déposés aux extrémités de la partie épaisse 20b de la membrane déformable 20.

Il est en outre possible de prévoir sur la surface supérieure 201 de la membrane déformable 20 une couche électriquement isolante (non représentée) telle qu'une couche de SiO₂. Les jauges de contraintes 30 et les supports d'assemblage 40 étant dans ce cas déposées sur la couche électriquement isolante.

Le support 10 présente une section externe identique à celle de la membrane déformable 20. Le support 10 comprend en outre une surface supérieure 101 et une surface inférieure 102 laquelle est destinée à être en contact avec la surface supérieure 201 de la membrane déformable 20 au cours d'un procédé qui sera décrit par la suite.

Le support 10 comprend des évidements latéraux 11 qui sont formés pour être en face des jauges de contrainte 30 et un évidement central 50 formé pour être en face de la partie fine 20b de la membrane déformable lorsque la membrane 20 et le support 10 sont assemblés. Le support 10 comprend de préférence au moins quatre évidements latéraux 11. Les évidements latéraux 11 présentent avantageusement une section circulaire.

Les évidements latéraux 11 et l'évidement central 50 sont formés à partir d'un substrat par des techniques de micro-usinage telle qu'une gravure KOH à une température déterminée et/ou une gravure profonde par ions réactifs (en anglais, « *Deep Reactive Ion Etch* », (DRIE)) dans un substrat de surface d'origine plane.

Le support 10 peut être un matériau à base de verre, de Silicium quartz, pyrex™, saphir, alumine, Si, SiC.

Le support 10 présente, par exemple, une épaisseur comprise entre 50 et 1000 µm.

Au cours d'un procédé de fabrication d'un capteur de pression, un support 10 est assemblé E1 à une membrane déformable 20 sur laquelle des jauges de contraintes 30 et des supports 40 d'assemblage ont été préalablement déposés.

L'assemblage E1 peut être effectué en mettant en oeuvre un scellement anodique ou au moyen d'une liaison moléculaire ou atomique avec ou sans couche intermédiaire, ou par brasage.

Bien entendu on peut envisager d'autres possibilités pour assembler le support 10 avec la membrane déformable 20, possibilités connues de l'homme du métier et qui ne seront pas plus décrites ici.

Après l'assemblage E1, on dépose E2, en une unique étape, au moins un matériau conducteur 60 dans les évidements latéraux 11 du support 10 et sur la surface supérieure 101 du support 10. Ainsi, le matériau conducteur 60 s'étend dans les évidements latéraux 11 pour être en contact avec les jauges de contraintes (30) et pour former ensuite des contacts électriques 61 en liaison avec les jauges de contraintes 30.

Un tel dépôt E2 comprend notamment le dépôt d'un film en matériau(x) conducteur(s) sur la surface supérieure 101 du support 10 (opposée à la surface inférieure 102 du support 10 en contact avec la membrane déformable 20).

Le/les matériau(x) conducteur(s) 60 peuvent être un film de polysilicium ultra-dopé superposé à un métal, un dépôt métallique seul, ou une composition de plusieurs couches métalliques.

Et de manière plus générale, le/les matériau(x) conducteur(s) 60 sont choisis parmi le groupe suivant : polysilicium ultra dopé, Au, Ag, Ni, Pt, TiW, Cu, Pd, Al, Ti, TiN.

Le dépôt d'au moins un matériau conducteur 60 est de préférence effectué par une technique de dépôt chimique en phase vapeur à basse pression (en anglais, « *Low Pressure Chemical Vapor Deposition* », (LPCVD)), mais peut aussi être réalisé par évaporation, électrodéposition ou pulvérisation.

En outre, bien que la température soit faible et la pression élevée, le film est polycristallin et présente des propriétés homogènes partout où il est déposé.

Un tel dépôt E2 présente l'avantage de pouvoir déposer un film épais de matériau conducteur 60, présentant une épaisseur allant jusqu'à plusieurs dizaines de µm, en particulier dans des cavités, profondes, du support 10 qui pourraient avoir été obtenues par le micro-usinage du support 10 pour effectuer les évidements 11. En d'autres termes, le matériau conducteur 60 remplit toutes les cavités des parois des évidements latéraux 11.

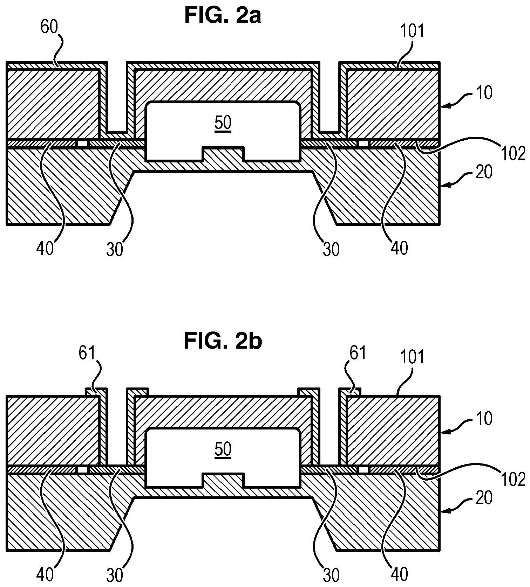

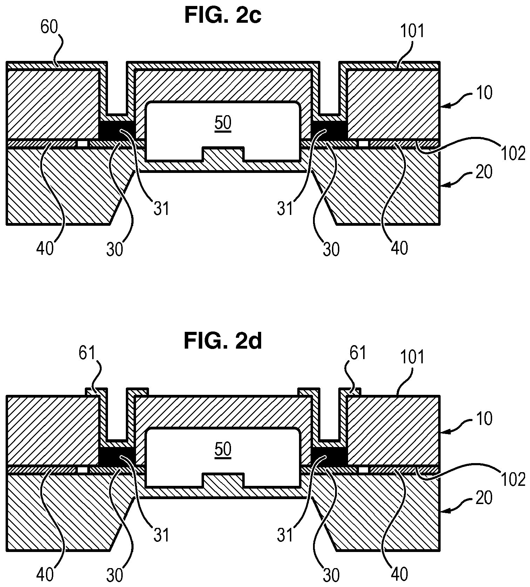

De cette façon, le ou les matériaux conducteurs 60 sont déposés sur l'ensemble de la surface supérieure 101 du support 10 et dans les évidements 11 latéraux (voir la figure 2).

Ensuite, le procédé de fabrication comprend une étape E3 de formation des contacts électriques 61. Une telle étape E3 est mise en oeuvre par photolithographie associé à une technique de laminage 3D à chaud ou de revêtement par pulvérisation d'un matériau photosensible (en anglais, « *spray coating* »). De cette façon, les zones utiles des contacts électriques 61 sont restreintes de manière précise.

En effet, la technique de photolithographie 3D associée à une technique de laminage à chaud ou de revêtement par pulvérisation d'un matériau photosensible permet de définir des zones de dépôt et des zones d'épargnes sur des surfaces présentant une forte topologie ; cette technique permet de maitriser l'homogénéité du dépôt, même sur des surfaces inclinées ou au fond des cavités. A titre d'exemple, cette technique permet de définir des structures de l'ordre de dix à quelques dizaines de microns au fond des évidements 11 qui sont de profondeur de l'ordre de 500µm, pour une largeur à la base de l'ordre de 100µm.

Après le dépôt E2 d'au moins un matériau conducteur 60 au cours d'une étape unique, la photolithographie 3D permet de pouvoir usiner les matériaux ainsi déposés après l'étape d'assemblage E1 entre le support 10 et la membrane 20, et ainsi de pouvoir réaliser E3 des formes structurées complexes présentant des variations de hauteurs de plusieurs centaines de µm, comme par exemple l'intérieur des évidements 11.

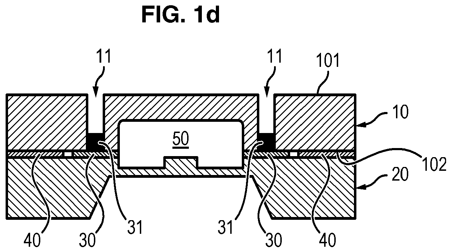

A l'issue de l'étape E3 de formation des contacts électriques les contacts électriques 61 sont connectés aux jauges de contraintes 30 (voir la figure 2b) et étendent à partir de la surface supérieure 101 du support 10. À titre d'exemple ne faisant pas partie de l'invention, une fois l'assemblage E1 effectué et avant l'unique étape E2 de dépôt d'au moins un matériau conducteur 60, le procédé de fabrication comprend une étape E10 de dépôt dans chaque évidement latéral 11, d'une barrière de diffusion 31 en contact avec les jauges de contraintes (30) correspondantes (voir la figure 1d).

La barrière de diffusion 31 est constituée d'un métal tel que du TiW, TiN, Pt, Ta, etc. De manière plus générale, la barrière de diffusion 31 est constituée d'un matériau dont les propriétés lui permettent de bloquer la diffusion d'une autre espèce atomique dans les jauges de contraintes 30.

Ensuite, comme décrit précédemment les contacts électriques sont formés (étape E3).

La barrière de diffusion 31 est en matériau conducteur comme le matériau servant à la formation des contacts électriques. Ainsi, comme on l'aura compris, dans chaque évidement latéral 11, les contacts électriques 61 sont en contact avec la barrière de diffusion 31 elle-même en contact avec la jauge de contrainte 30 correspondante. La barrière de diffusion participe alors au contact électrique 61 formé dans chaque évidement 11.Après avoir obtenu les contacts électriques 61, on intègre E4 la structure support 10 membrane déformable 20 à un boitier 80 comprenant des contacts électriques 81.

Les contacts électriques du boitier 80 sont en matériau choisi parmi le groupe suivant : polysilicium ultra dopé, Au, Ag, Ni, Pt, TiW, Cu, Pd, Al, Ti, TiN.

Le boitier 80 peut être constitué de différents matériaux, à base de verre, céramique ou métal, ou un assemblage des trois, et avoir diverses formes.

Les contacts électriques 81 du boitier 80 sont disposés de telle sorte qu'ils soient en face des contacts électriques 61 du support 10. La connexion électrique entre les contacts 61 et les contacts 81 peut se faire par la technique du câblage sans fil (en anglais, « *wire bonding* ») (technique classiquement utilisée pour les capteurs de pression) ou par une technique de contact direct.

Les contacts électriques 81 du boitier 80 s'étendent vers l'extérieur du boitier 80 pour permettre l'acquisition des signaux électriques générés pendant la mesure de la pression P.

Pour intégrer E4 la structure support 10/membrane déformable 20 au boitier 80, on peut mettre en oeuvre différentes techniques comme la technique connue dite de la puce retournée (en anglais, « *Flip chip* »).

Pour connecter les contacts électriques entre eux, on peut mettre en oeuvre en particulier un procédé de thermocompression à une température comprise entre 200°C et 500°C, et à une pression comprise entre 10 MPa et 250 MPa.

## Revendications

1. Procédé de fabrication d'un capteur de pression comprenant les étapes suivantes :
assemblage (E1) d'un substrat support (10) avec une membrane déformable (20) sur laquelle des jauges de contraintes (30) ont été déposées, la membrane déformable comprenant une zone amincie (20b) en son centre, le substrat support (10) étant disposé au-dessus de la membrane déformable (20), le substrat support (10) comprenant une surface supérieure (101), une surface inférieure (102) en contact avec la membrane déformable (20), le substrat support (10) comprenant en outre des évidements latéraux (11) disposés au-dessus et en face des jauges de contraintes (30) et un évidement central (50) disposé au-dessus la zone amincie (20b) de la membrane (20), ceci pour obtenir une structure micromécanique ; et une fois l'assemblage effectué, le procédé comprenant l'étape suivante :
dépôt (E2) en une unique étape d'au moins un matériau conducteur (60) sur la surface supérieure (101) du support et dans les évidements latéraux (11) du support (10), le matériau conducteur (60) s'étendant dans les évidements (11) pour être en contact direct avec les jauges de contraintes (30) afin de former des contacts électriques (61) en liaison avec les jauges de contraintes (30).

2. Procédé selon la revendication 1, comprenant une étape (E3) de formation de plusieurs contacts électriques (61) mise en oeuvre par photolithographie associé à une technique de laminage 3D à chaud ou de revêtement par pulvérisation de surfaces de forte topologie.

3. Procédé selon l'une des revendications précédentes, dans lequel le ou les matériau(x) conducteur(s) sont choisis parmi le groupe suivant : polysilicium ultra dopé, Au, Ag, Ni, Pt, TiW, Cu, Pd, Al, Ti, TiN.

4. Procédé selon l'une des revendications précédentes, dans lequel la membrane est en silicium et :
- le support (10) est en verre, l'assemblage (E1) consistant en un scellement anodique ; ou
- le support (10) est en silicium, l'assemblage (E1) consistant en un scellement au moyen d'une liaison moléculaire ou atomique avec ou sans couche intermédiaire, ou par brasage.

5. Procédé selon l'une des revendications 1 à 4, dans lequel la membrane (20) est formée à partir d'un substrat, par exemple constitué de silicium monocristallin comme le SOI ou le PSOI, de saphir comme le SOS ou bien d'autres matériaux comme le SiCOI ou le SiC.

6. Procédé selon l'une des revendications précédentes, comprenant une étape consistant à :
- intégrer (E4) le support (10) à un boitier (80) comprenant des contacts électriques (81) en matériau conducteur; le support étant intégré au boitier par l'intermédiaire des connecteurs formés sur le support.

7. Procédé selon la revendication précédente, dans lequel l'intégration (E4) du support au boitier est effectuée par un procédé de thermo-compression.

8. Procédé selon la revendication précédente, dans lequel le procédé de thermo compression est mis en oeuvre avec une température comprise entre 250°C et 500°C, typiquement 320°C avec une pression comprise entre 10 MPa et 200 MPa, typiquement 50 MPa.

9. Procédé selon l'une des revendications 6 à 8, dans lequel les contacts électriques du boitier (80) sont en matériau choisi parmi le groupe suivant : polysilicium ultra dopé, Au, Ag, Ni, Pt, TiW, Cu, Pd, Al, Ti, TiN.

10. Procédé selon l'une des revendications 6-9 dans lequel l'intégration (E4) du substrat support (10) au boitier (80) est mise en oeuvre au moyen de la technique de la puce retournée.

## Patentansprüche

1. Verfahren zur Herstellung eines Drucksensors, das die folgenden Schritte umfasst:
Zusammenfügen (E1) eines Trägersubstrats (10) mit einer verformbaren Membran (20), auf der Dehnungsstreifen (30) abgeschieden wurden, wobei die verformbare Membran in ihrer Mitte einen verdünnten Bereich (20b) umfasst, wobei das Trägersubstrat (10) über der verformbaren Membran (20) angeordnet wird, wobei das Trägersubstrat (10) eine obere Fläche (101), eine untere Fläche (102) in Kontakt mit der verformbaren Membran (20) umfasst, wobei das Trägersubstrat (10) weiter seitliche Ausnehmungen (11) umfasst, die über und den Dehnungsstreifen (30) zugewandt angeordnet werden, und eine mittige Ausnehmung (50), die über dem verdünnten Bereich (20b) der Membran (20) angeordnet wird, um eine mikromechanische Struktur zu erhalten; und wobei das Verfahren, sobald das Zusammenfügen erfolgt ist, den folgenden Schritt umfasst:
Abscheiden (E2), in einem einzigen Schritt, von mindestens einem leitenden Material (60) auf der oberen Fläche (101) des Trägers und in den seitlichen Ausnehmungen (11) des Trägers (10), wobei sich das leitende Material (60) so in den Ausnehmungen (11) erstreckt, dass es sich mit den Dehnungsstreifen (30) in direktem Kontakt befindet, um in Verbindung mit den Dehnungsstreifen (30) elektrische Kontakte (61) zu bilden.

2. Verfahren nach Anspruch 1, das einen Schritt (E3) des Bildens von mehreren elektrischen Kontakten (61) umfasst, der durch Fotolithographie zusammen mit einer 3D-Heißlaminierungs- oder Pulverbeschichtungstechnik für Flächen mit starker Topologie umgesetzt wird.

3. Verfahren nach einem der vorstehenden Ansprüche, wobei das oder die leitende (n) Material (ien) aus der folgenden Gruppe ausgewählt ist/sind: ultradotiertes Polysilizium, Au, Ag, Ni, Pt, TiW, Cu, Pd, Al, Ti, TiN.

4. Verfahren nach einem der vorstehenden Ansprüche, wobei die Membran aus Silizium ist und:
- der Träger (10) aus Glas ist, wobei das Zusammenfügen (E1) in einem anodischen Bonden besteht; oder
- der Träger (10) aus Silizium ist, wobei das Zusammenfügen (E1) in einem Bonden mittels einer Molekül- oder Atombindung mit oder ohne Zwischenschicht, oder durch Löten besteht.

5. Verfahren nach einem der Ansprüche 1 bis 4, wobei die Membran (20) auf Grundlage eines Substrats gebildet wird, das zum Beispiel aus einkristallinem Silizium, wie SOI oder PSOI, aus Saphir, wie SOS, oder auch anderen Materialien wie SiCOI oder SiC besteht.

6. Verfahren nach einem der vorstehenden Ansprüche, das einen Schritt umfasst des:
- Integrierens (E4) des Trägers (10) in ein Gehäuse (80), das elektrische Kontakte (81) aus leitendem Material umfasst; wobei der Träger mit Hilfe der auf dem Träger gebildeten Verbinder in das Gehäuse integriert wird.

7. Verfahren nach dem vorstehenden Anspruch, wobei das Integrieren (E4) des Trägers in das Gehäuse durch ein Thermokompressionsverfahren erfolgt.

8. Verfahren nach dem vorstehenden Anspruch, wobei das Thermokompressionsverfahren mit einer Temperatur im Bereich zwischen 250 °C und 500 °C, typischerweise 320 °C, mit einem Druck im Bereich zwischen 10 MPa und 200 MPa, typischerweise 50 MPa, umgesetzt wird.

9. Verfahren nach einem der Ansprüche 6 bis 8, wobei die elektrischen Kontakte des Gehäuses (80) aus Material sind, das aus der folgenden Gruppe ausgewählt ist: ultradotiertes Polysilizium, Au, Ag, Ni, Pt, TiW, Cu, Pd, Al, Ti, TiN.

10. Verfahren nach einem der Ansprüche 6-9, wobei das Integrieren (E4) des Trägersubstrats (10) in das Gehäuse (80) mittels der Flip-Chip-Technik umgesetzt wird.

## Claims

1. A manufacturing method of a pressure sensor comprising the following steps:
assembling (E1) a support substrate (10) with a deformable membrane (20) on which strain gauges (30) have been deposited, the deformable membrane comprising a thinned zone (20b) in its centre, the support substrate (10) being arranged above the deformable membrane (20), the support substrate (10) comprising an upper surface (101), a lower surface (102) in contact with the deformable membrane (20), the support substrate (10) further comprising lateral recesses (11) arranged above the strain gauges (30) and a central recess (50) arranged above the thinned zone (20b) of the membrane (20), to obtain a micromechanical structure; and once the assembly is complete the method comprising the following step:
depositing (E2) in a single step of at least one conductive material (60) on the upper surface (101) of the support and in the lateral recesses (11) of the support (10), the conductive material (60) extending into the recesses (11) to be in contact with the strain gauges (30) to form electrical contacts (61) linked to the strain gauges (30).

2. The method according to claim 1, comprising a step (E3) of forming several electrical contacts (61) executed by photolithography associated with a 3D hot laminating technique or coating by pulverisation of surfaces of strong topology.

3. The method according to any of the preceding claims, wherein the conductive material(s) are selected from the following group: ultradoped polysilicon, Au, Ag, Ni, Pt, TiW, Cu, Pd, Al, Ti, TiN.

4. The method according to any of the preceding claims, wherein the membrane is made of silicon and:
- the support (10) is made of glass, the assembly (E1) consisting of an anodic sealing; or
- the support (10) is made of silicon, the assembly (E1) consisting of sealing by means of a molecular or atomic bond with or without intermediate layer, or by brazing.

5. The method according to any of claims 1 to 4, wherein the membrane (20) is formed from a substrate, for example constituted by monocrystalline silicon such as SOI or PSOI, sapphire such as SOS or else other materials such as SiCOI or SiC.

6. The method according to any of the preceding claims, comprising a step consisting of:
- integrating (E4) the support (10) into a casing (80) comprising electrical contacts (81) made of conductive material; the support being integrated into the casing by means of connectors formed on the support.

7. The method according to the preceding claim, wherein integration (E4) of the support into the casing is completed by a thermo-compression method.

8. The method according to the preceding claim, wherein the method of thermo compression is executed at a temperature between 250°C and 500°C, typically 320°C with pressure between 10 MPa and 200 MPa, typically 50 MPa.

9. The method according to any of claims 6 to 8, wherein the electrical contacts of the casing (80) are made of material selected from the following group: ultradoped polysilicon, Au, Ag, Ni, Pt, TiW, Cu, Pd, Al, Ti, TiN.

10. The method according to any of claims 6 to 9, wherein integration (E4) of the support substrate (10) into the casing (80) is executed by means of the technique of the flipped chip.
